(19) Europäisches Patentamt
European Patent Office
Office européen des brevets

(11) **EP 2 669 916 A1**

(12) **EUROPEAN PATENT APPLICATION**

(43) Date of publication:
**04.12.2013 Bulletin 2013/49**

(21) Application number: **13182301.5**

(22) Date of filing: **28.03.2011**

(51) Int Cl.:
***H01G 9/20*** *(2006.01)* *C07F 15/00* *(2006.01)*
*C09B 57/10* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.04.2010 KR 20100031034**

(62) Document number(s) of the earlier application(s) in accordance with Art. 76 EPC:
**11159961.9 / 2 372 734**

(71) Applicant: **Samsung SDI Co., Ltd.**
**Gyeonggi-do (KR)**

(72) Inventors:
- **Kang, Moon-Sung**
  **Yongin-si (Gyeonggi-do) (KR)**
- **Lee, Ji-Won**
  **Yongin-si (Gyeonggi-do) (KR)**
- **Shin, Byong-Cheol**
  **Yongin-si (Gyeonggi-do) (KR)**
- **Ko, Jae-Jung**
  **339-700 Yongin-si (Gyeonggi-do) (KR)**
- **Choi, Hyun-Bong**
  **339-700 Yongin-si (Gyeonggi-do) (KR)**

(74) Representative: **Santarelli**
**14 Avenue de la Grande Armée**
**B.P. 237**
**75822 Paris Cedex 17 (FR)**

Remarks:
This application was filed on 29-08-2013 as a divisional application to the application mentioned under INID code 62.

# (54) Ruthenium complex and dye-sensitized fuel cell using the same

(57) A ruthenium complex having at least one selected from an alkyl thiophene unit and a unit in which thiophenes are linked to aromatic rings in the form of a pentagonal ring and a dye-sensitized solar cell (9) using the same (15).

FIG. 1

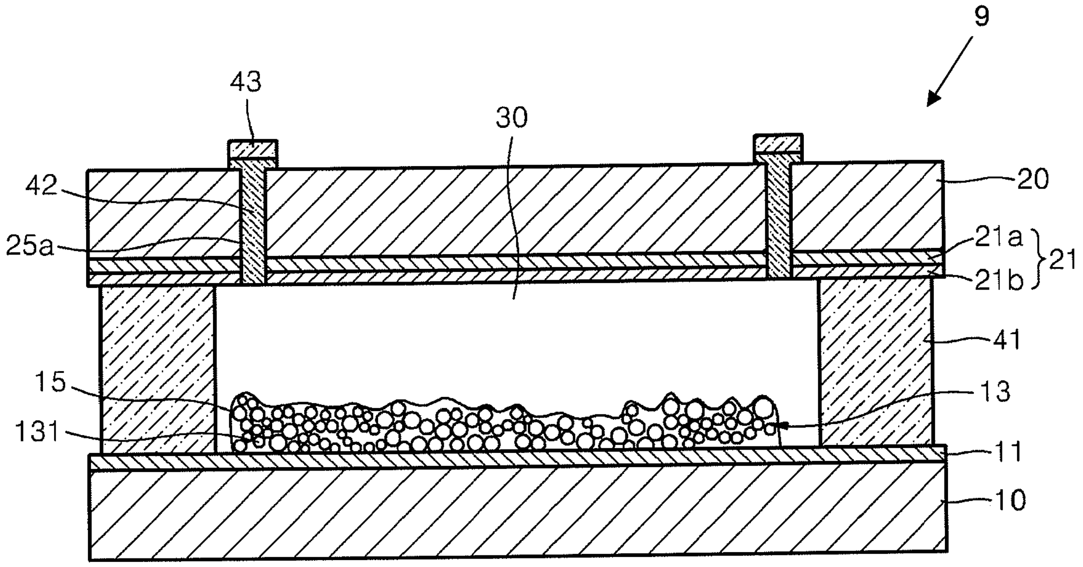


EP 2 669 916 A1

## Description

BACKGROUND

Field

The present invention, illustrated by one or more embodiments, relates to a ruthenium complex and a dye-sensitized solar cell using the same.

Description of the Related Technology

Unlike silicon solar cells, dye-sensitized solar cells are photoelectrochemical solar cells that are composed of photosensitive dye molecules, as main constituents, that may produce electron-hole pairs by absorbing visible rays, and a transition metal oxide that transfers the produced electrons. Dye-sensitized solar cells may be manufactured at lower cost than silicon-based solar cells, and since they use transparent electrodes, the cells may be applied to external glass walls of a building or glass greenhouse. However, many dye-sensitized solar cells have limited practical application due to their low photoelectric conversion efficiency.

The photoelectric conversion efficiency of a dye-sensitized solar cell is proportional to the quantity of electrons produced from the absorption of solar beams. Thus, to increase the photoelectric conversion efficiency, the quantity of the produced electrons may be increased by absorbing more sunlight or by increasing the amount of dye adsorbed, or the produced and excited electrons may be prevented from being used to cause electron-hole recombination.

To increase the adsorption amount of dye per unit area, oxide semiconductor particles can be nano-sized, and, to increase the absorption of the sunlight, the reflectivity of a platinum electrode may be increased, or a micro-sized oxide semiconductor light scattering agent should be included to increase the absorption of solar beams. However, these conventional methods have limitations in terms of increasing the photoelectric conversion efficiency of dye-sensitized solar cells. Therefore, there is an urgent need to develop a novel method of improving the photoelectric conversion efficiency of the dye-sensitized solar cells. The present invention illustrated by its embodiments overcomes the above problems as well as provide additional advantages.

SUMMARY

An object of the invention, illustrated by one or more embodiments, is a ruthenium complex having excellent thermal stability and a dye-sensitizing solar cell using the same, whereby the photoelectric conversion efficiency is enhanced.

Additional aspects will be set forth in part in the description which follows and, in part, will be apparent from the description, or may be learned by practice of the presented embodiments.

According to one or more embodiments, a ruthenium complex represented by Formula 1 below is provided.

Formula 1

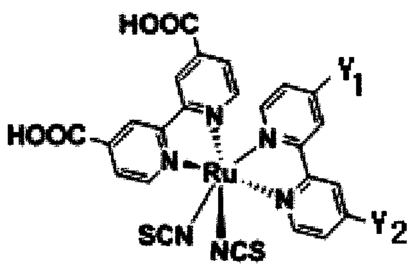

wherein $Y_1$ and $Y_2$ are each independently selected from the groups represented by Formula 2 and Formula 2A below,

Formula 2

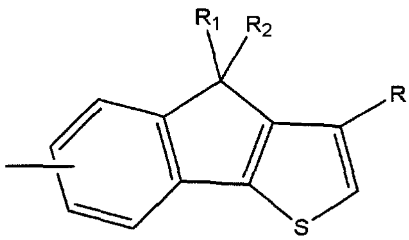

Formula 2A

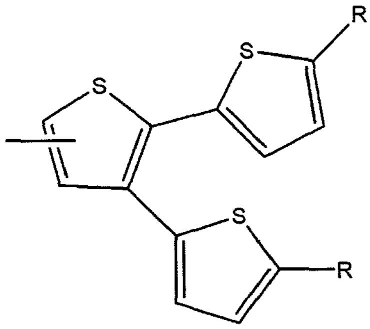

wherein $R_1$ and $R_2$ are each independently hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and
R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.
According to one or more embodiments, another object of the invention is a dye-sensitized solar cell which includes:

a first electrode, a light absorption layer formed on a surface of the first electrode, a second electrode disposed to face the first electrode on the face on which the light absorption layer is formed, and an electrolyte disposed between the first electrode and the second electrode, the light absorption layer being porous to the electrolyte; and
a dye adsorbed layer onto the light absorption layer comprising the ruthenium complex represented by Formula 1.

BRIEF DESCRIPTION OF THE DRAWINGS

These and/or other aspects will become apparent and more readily appreciated from the following description of the embodiments, taken in conjunction with the accompanying drawings of which:
FIG. 1 is a schematic cross-sectional view illustrating a structure of a dye-sensitized solar cell according to an embodiment of the invention;
FIG. 2 is a graph showing variation in incident photon to current efficiency (IPCE) with respect to unit wavelength of dye-sensitized solar cells manufactured according to Preparation Examples 1 and 2;
FIG. 3 is a graph showing UV-photoluminescence (PL) characteristics of compounds represented by Formulae 4 and 5, prepared according to Synthesis Examples 1 and 2, and of the N 179 dye used in the dye-sensitized solar cell manufactured according to Comparative Preparation Example 1; and
FIG. 4 is a graph showing variation in current with respect to voltage of dye-sensitized solar cells manufactured according to Preparation Examples 1 and 2.

DETAILED DESCRIPTION

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description.
According to an embodiment, there is provided a ruthenium complex represented by Formula 1 below:

Formula 1

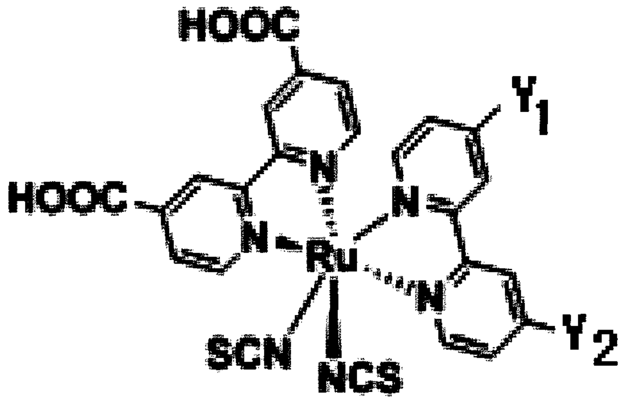

wherein $Y_1$ and $Y_2$ are each independently selected from the groups represented by Formula 2 and Formula 2A below,

Formula 2

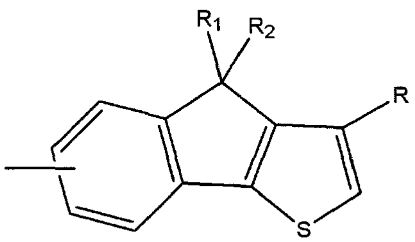

Formula 2A

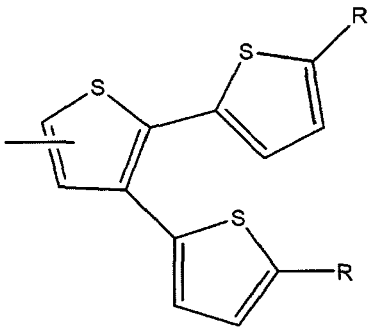

wherein $R_1$ and $R_2$ are each independently hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and

R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

The groups represented by Formula 2 and Formula 2A may be selected from the groups represented by the following Formula 3 and Formula 3A:

Formula 3

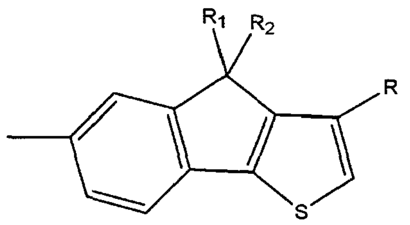

Formula 3A

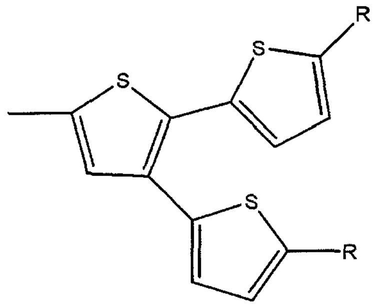

wherein $R_1$ and $R_2$ are each independently hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and

R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

In Formula 1, $Y_1$ and $Y_2$ may be each independently a group represented by the following formula:

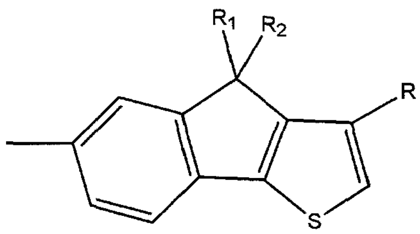

Formula 3

wherein $R_1$ and $R_2$ are each independently hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and

R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

In Formula 1, $Y_1$ and $Y_2$ may be each independently a group represented by the following formula:

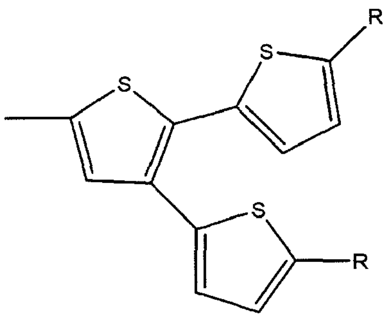

Formula 3A

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a sub-

stituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

Without wishing to be bound by any theory, the applicant believes that the ruthenium complex of Formula 1 advantageously tends to increase the conjugation length of ligands thereof and to introduce thiophene units, preferably hexyl thiophene units, that can increase molar absorptivity and absorption at long wavelength regions. In addition, the ruthenium complex of Formula 1 tends to introduce hydrophobic alkyl chains, that can prevent generation of dark current and agglomeration between molecules and thereby increase thermal stability of molecules.

In some embodiments the ruthenium complex of Formula 1 may be a compound represented by Formula 4 or 5;

Formula 4

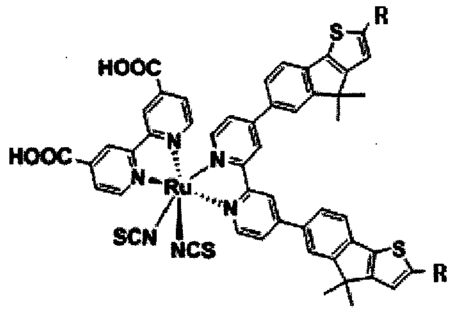

Formula 5

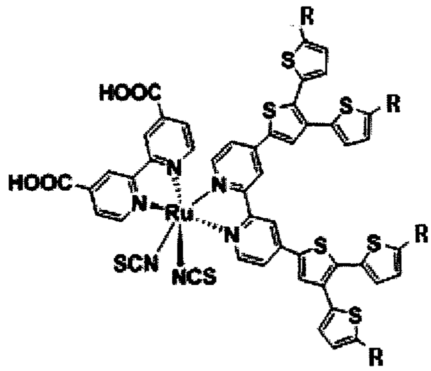

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

Without wishing to be bound by any theory, the applicant believes that the ruthenium complex of Formula 4 and the ruthenium complex of Formula 5 each have a structure in which thiophenes are advantageously linked to aromatic rings in the form of a pentagonal ring, and have a branched alkyl thiophene unit introduced thereinto, thereby effectively tending to increase the conjugation length of ligands.

A method of preparing the ruthenium complex of Formula 1 will now be described.

First, Compound (B) (below) is added to a compound represented by Formula 6 below, the mixture is first heat-treated, then 2,2'-bipyridyl-4,4'-dicarboxylic acid (C) is added to the heat-treated resultant, and a second heat-treatment is performed thereon.

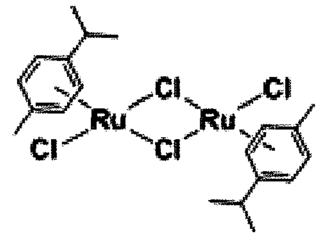

(B)

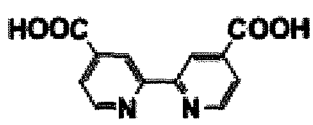

(C)

Formula 6

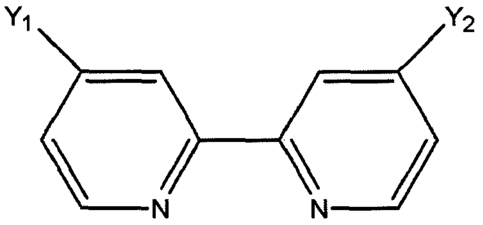

wherein $Y_1$ and $Y_2$ are each independently selected from the groups represented by Formula 2 and Formula 2A below,

Formula 2

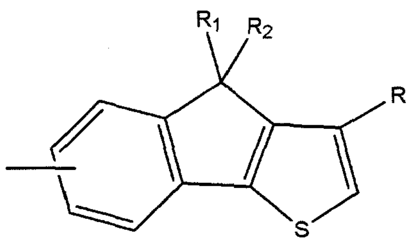

Formula 2A

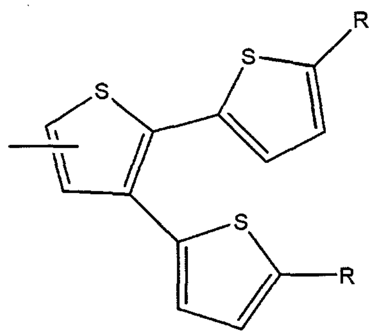

wherein $R_1$ and $R_2$ are each independently hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and

R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

An excess amount of $NH_4NCS$ is added to the second heat-treated reaction mixture, and a third heat-treatment is performed on the resultant mixture to obtain the ruthenium complex of Formula 1.

The first heat-treatment process is performed at a temperature of from about 50 to about 200°C, and the second and third heat-treatment processes are performed at a temperature of from about 100 to about 200°C.

The ruthenium complex of Formula 1 may be used as a dye for a dye-sensitized solar cell.

FIG. 1 is a schematic cross-sectional view illustrating a structure of a dye-sensitized solar cell 9 according to an embodiment of the invention.

Referring to FIG. 1, the dye-sensitized solar cell according to the present embodiment includes a first substrate 10 on which a first electrode 11, a light absorption layer 13, and a dye 15 are formed, a second substrate 20 on which a second electrode 21 is formed, and an electrolyte 30 disposed between the first electrode 11 and the second electrode 21 such that the first substrate 10 and the second substrate 20 face each other. A case (not shown) may be disposed at an outer side of the first substrate 10 and the second substrate 20. The structure of the dye-sensitized solar cell 9 will

now be further described.

In the present embodiment, the first substrate 10, which supports the first electrode 11, may be transparent to allow external light to be incident to the first substrate 10. Thus, the first substrate 10 may be formed of glass or plastic, for example. The plastic may be, for example, polyethylene terephthalate (PET), polyethylene naphthalate (PEN), polycarbonate (PC), polypropylene (PP), polyimide (PI), triacetyl cellulose (TAC), or the like.

The first electrode 11 formed on the first substrate 10 may be formed of a transparent material such as ZnO-$Ga_2O_3$, ZnO-$Al_2O_3$, at least one selected from indium tin oxide, indium oxide, tin oxide, zinc oxide, sulfur oxide, fluorine oxide, and mixtures thereof, or the like. The first electrode 11 may be in the form of a single film or laminated film formed of the transparent material.

The light absorption layer 13 (photo electrode) is formed on the first electrode 11. The light absorption layer 13 includes titanium oxide particles 131, and has an appropriate average pore size, thereby easily transferring the electrolyte 30.

The thickness of the light absorption layer 13 may be from about 10 to about 3000 nm, for example, from about 10 to about 1000 nm. However, the present invention is not limited thereto, and the thickness of the light absorption layer 13 may vary according to technology advancement, and the like.

The dye 15 that absorbs external light to produce excited electrons is adsorbed onto a surface of the light absorption layer 13. The dye 15 may be the ruthenium complex of Formula 1. For example, one of the compounds of Formulae 4 and 5 may be used as the dye 15.

The second substrate 20 disposed to face the first substrate 10 supports the second electrode 21, and may be transparent. Thus, the second substrate 20 may be formed of glass or plastic, as is the first substrate 10.

The second electrode 21 formed on the second substrate 20 is disposed to face the first electrode 11, and may include a transparent electrode 21a and a catalyst electrode 21b.

The transparent electrode 21a may be formed of a transparent material such as indium tin oxide, fluoro tin oxide, antimony tin oxide, zinc oxide, tin oxide, ZnO-$Ga_2O_3$, ZnO-$Al_2O_3$, or the like. The transparent electrode 21a may be in the form of a single film or a laminated film formed of the transparent material.

The catalyst electrode 21b activates redox couples, and may be a platinum electrode.

The first substrate 10 and the second substrate 20 are attached to each other using an adhesive 41. The electrolyte 30 is injected into the interior between the first electrode 11 and the second electrode 21 through holes 25a that penetrate the second substrate 20 and the second electrode 21. The electrolyte 30 is uniformly diffused into the light absorption layer 13. The electrolyte 30 receives electrons from the second electrode 21 and transfers the electrons to the dye 15 through reduction and oxidation. The holes 25a penetrating the second substrate 20 and the second electrode 21 are sealed by an adhesive 42 and a cover glass 43.

Although not illustrated in FIG. 1, a metal oxide film, which can be a general porous film, may be further formed between the first electrode 11 and the light absorption layer 13. In this regard, the light absorption layer 13 acts as a light scattering electrode and is capable of adsorbing a large amount of dye, thereby addressing the disadvantages of conventional light scattering electrodes. Accordingly, the dye-sensitized solar cell may have high efficiency.

The porous film may be formed of metal oxide particles, and examples of the metal oxide may include titanium oxide, zinc oxide, tin oxide, strontium oxide, indium oxide, iridium oxide, lanthan oxide, vanadium oxide, molybdenum oxide, tungsten oxide, niobium oxide, magnesium oxide, aluminum oxide, yttrium oxide, scandium oxide, samarium oxide, gallium oxide, and strontium titanium oxide. The metal oxide particles may also be $TiO_2$ particles, $SnO_2$ particles, $WO_3$ particles, ZnO particles, or complexes thereof.

The substituents in Formulae 1, 2, 2A, 3, 3A, 4, 5 and 6 are discussed below.

The alkyl group used herein is in a linear or branched form, and may be, for example, methyl, ethyl, propyl, isobutyl, sec-butyl, pentyl, iso-amyl, hexyl, heptyl, octyl, nonanyl, dodecyl, or the like. At least one hydrogen atom of the alkyl group may be substituted with a deuterium atom, a halogen atom, a hydroxyl group, a nitro group, a cyano group, an amino group, an amidino group, hydrazine, hydrazone, a carboxyl group or salts thereof, a sulfonic acid group or salts thereof, a phosphoric acid or salts thereof, a $C_1$-$C_{10}$ alkyl group, a $C_1$-$C_{10}$ alkoxy group, a $C_2$-$C_{10}$ alkenyl group, a $C_2$-$C_{10}$ alkynyl group, a $C_6$-$C_{16}$ aryl group, or a $C_4$-$C_{16}$ heteroaryl group.

The alkoxy group used herein may be, for example, a group represented by -OA where A is an unsubstituted $C_1$-$C_{50}$ alkyl group, and may be, for example, methoxy, ethoxy, propoxy, isopropyloxy, butoxy, penthoxy, or the like. At least one hydrogen atom of the alkoxy group may be substituted with the same substituent as in the alkyl group described above.

The aryl group used herein is used alone or in combination, and refers to a carbocyclic aromatic system containing at least one ring, wherein the rings can be attached to each other using a pedant method or fused with each other. The term "aryl" refers to an aromatic radical, including, for example, phenyl, naphthyl, tetrahydronaphthyl, or the like. At least one hydrogen atom of the aryl group may be substituted with the same substituents as in the alkyl group described above.

The heteroaryl group used herein refers to an aromatic organic compound which contains at least one heteroatom selected from the group consisting of nitrogen (N), oxygen (O), phosphorus (P), and sulfur (S). At least one hydrogen atom of the heteroaryl group may be substituted with the same substituent as in the alkyl groups described above.

The heterocyclic group used herein refers to a ring group containing a heteroatom such as N, S, P, or O. At least one hydrogen atom of the heterocyclic group may be substituted with the same substituent as in the alkyl groups described above.

The carbocyclic group used herein refers to a cyclic alkyl group. At least one hydrogen atom of the carbocyclic group may be substituted with the same substituent as in the alkyl groups described above.

The alkylene group used herein may be, for example, methylene, ethylene, or the like. At least one hydrogen atom of the alkylene group may be substituted with the same substituent as in the alkyl groups described above.

At least one hydrogen atom of the alkenylene group and the alkynylene group may be substituted with the same substituent as in the alkyl group described above.

The arylene group used herein may be, for example, phenylene, biphenylene, or the like, and at least one hydrogen atom of the arylene group may be substituted with the same substituent as in the alkyl groups described above.

At least one hydrogen atom of the heteroarylene group may be substituted with the same substituent as in the alkyl groups described above.

Each of the heteroaryloxy group, the arylalkyl group, the aryloxy group, the carbocyclic alkyl group, the heterocyclic alkyl group, and the heteroarylalkyl group may be substituted with the same substituent as in the alkyl groups described above.

One or more embodiments will now be described in further detail with reference to the following examples. However, these examples are for illustrative purposes only and are not intended to limit the scope of the invention.

EXAMPLES

The compound of Formula 4 wherein R is a hexyl group (JK-105) is synthesized according to Synthesis Example 1 below and the compound of Formula 5 wherein R is a hexyl group (JK-108) is synthesized according to Synthesis Example 2. The syntheses are as depicted in Reaction Scheme 1 below:

Reaction Scheme 1

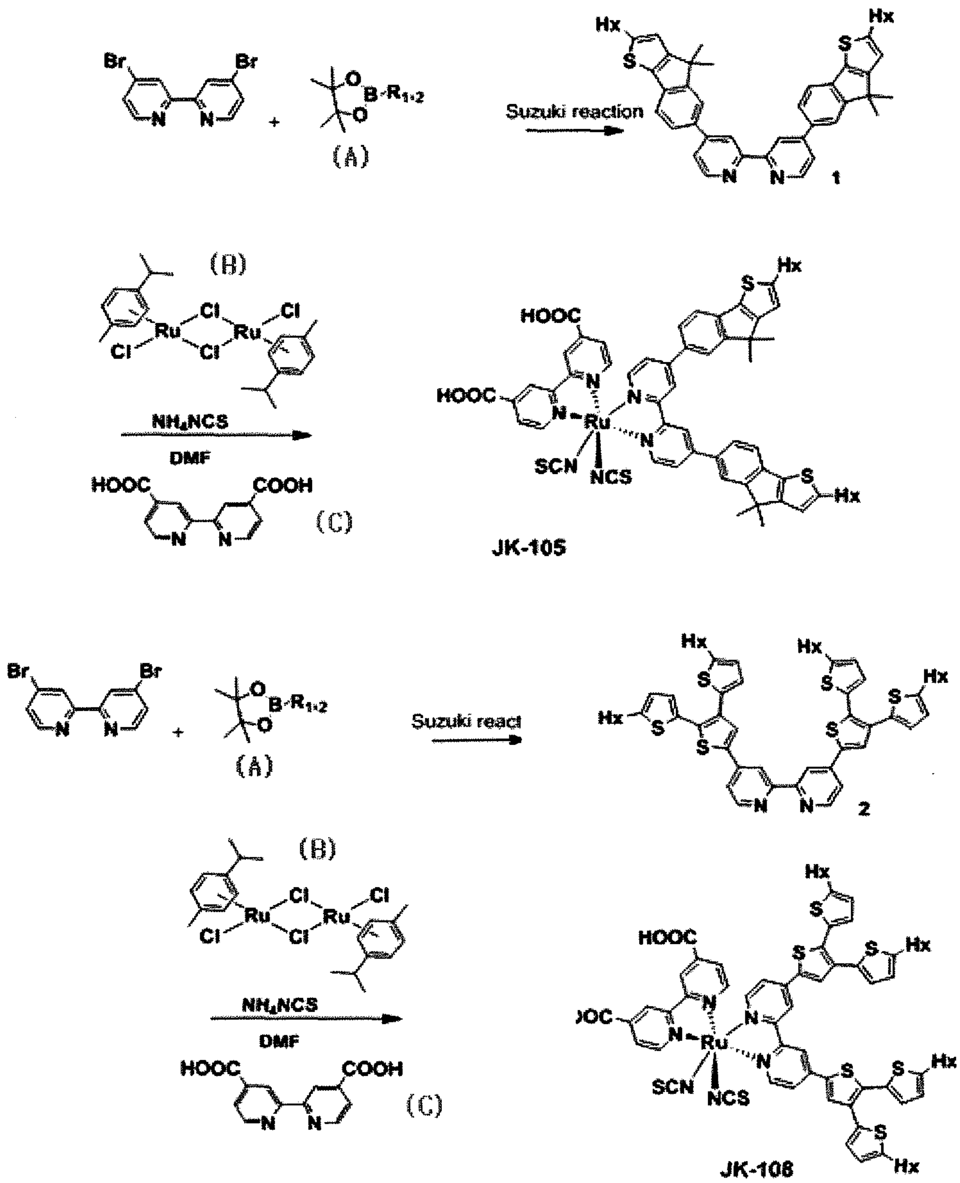


In Reaction Scheme 1, Compound (A) represents 4,4'-dibromo-2,2'-bipyridine (1 mmol) and 2-(2-hexyl-4,4-dimethyl-4H-indeno[1,2-b]thiophene-6-yl)-4,4,5,5-tetramethyl-1,3,2-dioxaborolane, and $H_x$ represents a hexyl group.

Synthesis Example 1: Preparation of compound of Formula 4 (JK-105)

Preparation of Compound 1

1 mmol of 4,4'-dibromo-2,2'-bipyridine, 2.5 mmol of 2-(2-hexyl-4,4-dimethyl-4H-indeno[1,2-b]thiophene-6-yl)-4,4,5,5-tetramethyl-1,3,2-dioxaborolane, 10 mmol of potassium carbonate, and 0.1 mmol of triphenyl phosphine palladium {$Pd(PPh_3)_4$} were dissolved in a mixed solvent including tetrahydrofuran and water in a volume ratio of 2:1 (v/v), and the mixed solution was refluxed for 12 hours.

Water was added to the reaction mixture, and the resultant mixture was then extracted using dimethylene chloride and a separatory funnel. Magnesium sulfate was added to an extracted dimethylene chloride layer, and an organic solvent was removed therefrom. Silica gel column chromatography was performed on the resultant product to obtain Compound 1.

$^1$H NMR ($CDCl_3$):$\delta$ 8.77 (s, 2H), 7.76 (d, 2H, $J$ = 2.7Hz), 7.77 (s,2H), 7.70 (d, 2H, $J$ = 7.8Hz), 7.62 (dd, 2H, $J$ = 5.1Hz), 7.45 (d, 2H, $J$ = 7.8Hz), 6.78 (s, 2H), 2.88 (t, 4H, $J$ = 7.8Hz), 1.74 (m, 4H), 1.52 (s, 12H), 1.44-1.33 (m, 12H), 0.91 (t,

6H, *J*= 6.9Hz).

Preparation of JK-105

0.188 mmol of [{RuCl(p-cymene)}$_2$] Compound (B) was dissolved in N,N-methylformamide, and 2 equivalent weights of Compound 1 was added to the mixed solution.

The reaction mixture was refluxed at 80°C for 4 hours, and 2 equivalent weight of 2,2'-bipyridyl-4,4'-dicarboxylic acid (C) was added thereto.

The mixture was refluxed at 160°C for 4 hours, an excess amount of $NH_4NCS$ was added to the refluxed mixture, and the resultant mixture was refluxed at 130°C for 4 hours. N,N-dimethylformamide was removed from the reaction mixture, and water was added thereto to precipitate a solid.

Subsequently, tetrabutyl ammonium hydroxide dissolved in methanol was added to the obtained solid, and a compound was separated from the resultant mixture using a Sephadex LH-20 column.

The separated compound was dissolved in methanol, and 1 wt% of a nitric acid aqueous solution was added thereto until the pH of the resultant solution reached 5 to obtain a solid. The solid was filtered using filter paper to obtain Compound JK-105.

$^1$H NMR(DMSO-d$^6$):$\delta$9.57(d, 1H, $^3J$= 5.1Hz), 9.28(d, 1H, $^3J$= 5.1Hz), 8.96(s, 1H), 8.79(s, 1H), 8.64(s, 1H), 8.51(s, 1H), 8.20(d, 1H, $^3J$ = 4.8Hz), 7.91(s, 1H), 7.81(d, 1H, $^3J$ = 7.2Hz), 7.70-7.46(m,7H), 7.26(d, 1H, $^3J$ = 5.4Hz), 7.07(s, 1H), 6.80 (d, 2H, *J* = 11.4Hz), 2.81(t, 4H, *J*= 6.0Hz), 1.57-1.30(m, 28H), 0.95-0.84(m, 6H).

Synthesis Example 2: Preparation of Compound of Formula 5 (JK-108)

Preparation of Compound 2

1 mmol of 4,4'-dibromo-2,2'-bipyridine, 2.5 mmol of 2-(5'-hexyl-3-(5-hexylthiophene-2-yl)- 2,2'-bithiophene-5-yl)-4,4,5,5-tetramethyl-1,3,2-dioxaborolane Compound (A), 10 mmol of potassium carbonate, and 0.1 mmol of $Pd(PPh_3)_4$ were dissolved in a mixed solvent including prepared by dissolving tetrahydrofuran and water in a volume ratio of 2:1 (v/v), and the mixed solution was refluxed for 12 hours.

Water was added to the reaction mixture, and the resultant mixture was then extracted using dimethylene chloride and a separatory funnel. A dimethylene chloride layer was collected, magnesium sulfate was added thereto, and the resultant product containing organic layer collected by the filtration was dried to remove an organic solvent therefrom. Silica gel column chromatography was performed on the resultant product to obtain Compound 2.

$^1$H NMR($CDCl_3$):$\delta$8.686(d, 2H, $^3J$= 5.4Hz), 8.646(s, 2H), 7.650(s, 2H), 7.490(d, 2H, $^3J$= 4.8Hz), 7.017(d, 2H, $^3J$= 3.3Hz), 6.940(d, 2H, $^3J$= 3.9Hz), 6.708(m, 4H), 2.80(m, 8H), 1.66(m, 8H), 1.325(m, 24H), 0.89(m, 12H).

Preparation of JK-108

0.188 mmol of [{RuCl(p-cymene)}$_2$] Compound (B) was dissolved in N,N-methylformamide, and 2 equivalent weights of Compound 2 were added to the mixed solution.

The reaction mixture was refluxed at 80°C for 4 hours, and 2 equivalent weight of 2,2'-bipyridyl-4,4'-dicarboxylic acid (C) was added thereto.

The mixture was refluxed at 160°C for 4 hours, an excess amount of $NH_4NCS$ was added to the refluxed mixture, and the resultant mixture was refluxed at 130°C for 4 hours. N,N-dimethylformamide was removed from the reaction mixture, and water was added thereto to precipitate a solid. Subsequently, tetrabutyl ammonium hydroxide dissolved in methanol was added to the precipitated solid, and a compound was separated from the resultant mixture using a Sephadex LH-20 column.

The separated compound was dissolved in methanol, and 1 wt% of a nitric acid aqueous solution was added thereto until pH of the resultant solution reached 5 to obtain a solid. The solid was filtered using filter paper to obtain Compound JK-108.

$^1$H NMR (DMSO-d$^6$):$\delta$ 9.473(d, 1H, $^3J$=6Hz), 9.171(m, 2H), 9.053(1H), 8.992(1H), 8.912(1H), 8.316(2H), 8.195(1H), 8.119(1H), 7.943(d, 1H, $^3J$ =6Hz), 7.660(d, 1H, $^3J$ =5.4Hz), 7.449(1H), 7.362(1H), 7.141(s, 2H), 7.047(s, 2H), 6.85~6.80 (m, 4H), 2.76(m, 8H), 1.58(m, 8H), 1.269(m, 24H), 0.85(m, 12H).

Preparation Example 1: Manufacture of dye-sensitized solar cell

A dye-sensitized solar cell as shown in FIG. 1 was manufactured as explained below. A dispersion of titanium oxide particles each having a diameter of about 10 nm was coated on a 1cm$^2$ area of a conductive film, formed of ITO, of a first electrode by using a doctor blade. The resultant was heat-treated and sintered at 450°C for 30 minutes to

prepare a porous film having a thickness of 10 μm.

Subsequently, the temperature of the resultant was maintained at 80°C, and then the resultant was impregnated in 0.3 mM of a dye dispersion in which JK-105 was dissolved in ethanol, and a dye adsorption treatment was performed for 12 hours or more.

The dye-adsorbed porous film was cleaned using ethanol and dried at room temperature to manufacture the first electrode including a light absorption layer.

Separately, a platinum catalyst electrode was formed on the conductive film formed of ITO to form a second electrode. In order to facilitate injection of an electrolyte, fine holes were formed using a drill having a diameter of 0.75 mm.

A support that was formed of a thermoplastic polymer film (Surlyn, DuPont, USA) and having a thickness of 60 μm was positioned between the first electrode with the porous film formed thereon and the second electrode. Then, the resultant was pressed under pressure at 100°C for 9 seconds to join the first and second electrodes together. Then, the electrolyte was injected into the interior between the first electrode and the second electrode through the fine holes formed in the second electrode. The fine holes were sealed using a cover glass and a thermoplastic polymer film to complete the manufacture of the dye-sensitized solar cell.

The electrolyte used was prepared by dissolving 0.6 M of 1,2-dimethyl-3-hexylimidazolium iodide, 0.5 M of 4-tertbutylpyrimidine, 0.1 M of LiI, and 0.05 M of $I_2$ in acetonitrile.

Preparation Example 2: Manufacture of dye-sensitized solar cell

A dye-sensitized solar cell was manufactured in the same manner as in Preparation Example 1, except that the compound of Formula 5 wherein R is a hexyl group (JK-108) was used instead of the compound of Formula 4 wherein R is a hexyl group.

Comparative Preparation Example 1: Manufacture of dye-sensitized solar cell

A dye-sensitized solar cell was manufactured in the same manner as in Preparation Example 1, except that a N719 dye (Ruthenium complex dye) was used instead of the compound of Formula 4 wherein R is a hexyl group.

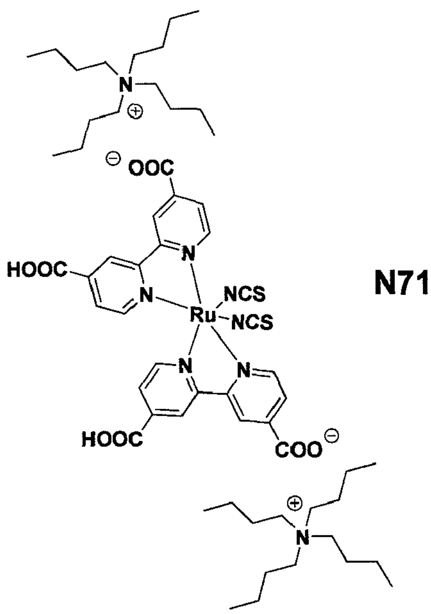

**N719**

The thermal stability of each of the compounds of Formulae 4 and 5 prepared according to Synthesis Examples 1 and 2, respectively was evaluated by measuring a melting point of each compound.

The compound of Formula 4 and the compound of Formula 5 each had a melting point of 400°C or higher. As a result of the evaluation, it is confirmed that each compound has excellent thermal stability.

In addition, cyclovoltammetry of each of the compounds of Formulae 4 and 5 (JK-105 and JK-108) respectively prepared according to Synthesis Examples 1 through 2 was measured, and the results are shown in Table 1 below.

Table 1

| Dye | $E_{redox}{}^{b}(\Delta E_p)$/V | $E_{0-0}{}^{c}$/V | $E_{LUMO}{}^{d}$/V |
|---|---|---|---|
| JK-108 | 1.01 | 1.78 | -0.77 |
| JK-105 | 0.93 | 1.95 | -1.02 |

From the results shown in Table 1, it is shown that lowest unoccupied molecular orbital (LUMO) potentials of the compounds of Formulae 4 and 5 are lower (i.e., - 0.77 V and -1.02 V, respectively (NHE basis)) than the potential of a conduction band (-0.5 V) of $TiO_2$, and thus the compounds of Formulae 4 and 5 had bands that facilitate electron injection. In addition, highest unoccupied molecular orbital (HOMO) potentials of the compounds of Formulae 4 and 5 are 1.01 V and 0.93 V, respectively (NHE basis), which are more positive values than a redox potential of $I^-/I_3^-$ (i.e., 0.4 V), and thus, it is shown that the compounds of Formulae 4 and 5 had bands that facilitate electron regeneration.

FIG. 2 is a graph showing variation in incident photon to current efficiency (IPCE) with respect to unit wavelength of the dye-sensitized solar cells manufactured according to Preparation Examples 1 and 2.

Referring to FIG. 2, the dye-sensitized solar cells of Preparation Examples 1 and 2 absorb visible rays with a wavelength of 750 nm or greater, thereby being capable of producing electricity. In addition, each dye-sensitized solar cell maintains a photoelectric conversion efficiency of 90% or greater at a wavelength in the range of 400 to 630 nm, and it is shown that each dye-sensitized solar cell exhibits high IPCE, which is close to about 90% while taking into consideration the reflection and absorption of glass.

FIG. 3 is a graph showing UV-photoluminescence (PL) characteristics of compounds represented by Formulae 4 and 5, according to the invention, and of the N179 dye used in the dye-sensitized solar cell manufactured according to comparative preparation example 1. UV/photoluminescence (UV/PL) characteristics of the compound of Formula 4 (JK-105) of Synthesis Example 1, the compound of Formula 5 (JK-108) of Synthesis Example 2, and the N719 dye used in the dye-sensitized solar cell manufactured according to Comparative Preparation Example 1 were evaluated, and the results are shown in Table 2 and FIG. 3 below.

Table 2

| Dye | $\lambda_{abs}$/nm ($\varepsilon$/$M^{-1}$-$cm^{-1}$) |
|---|---|
| JK-108 | 555 (16,900), 404 (27,000) |
| JK-105 | 522 (15,640), 378 (42,600) |

Referring to Table 2 and FIG. 3, JK-105 has maximum absorption coefficient at an absorption wavelength of 522 nm, JK-108 has maximum absorption coefficient at an absorption wavelength of 555 nm, and it is shown that an absorption wavelength band moves towards a long wavelength band certainly due to the effect of the introduced thiophene units. In addition, it is shown that the absorption coefficient of each compound is higher than that the higher absorption coefficient of the N719 dye (conventional ruthenium complex dye) in the interesting range (550 nm and higher) (absorption coefficient (s): 13,000).

Open-circuit voltage ($V_{OC}$), current density (Jsc), energy conversion efficiency ($E_{ff}$), and fill factor (FF) of each of the dye-sensitized solar cells of Preparation Examples 1 and 2 and Comparative Preparation Example 1 were measured, and the results are shown in Table 3 below.

The measurement conditions of the open-circuit voltage, current density, energy conversion efficiency, and fill factor in Table 3 below are as follows:

(1) Open-circuit voltage ($V_{OC}$) and current density (mA/$cm^2$)

The open-circuit voltage and the current density were measured using Keithley SMU2400.

(2) Energy conversion efficiency (%) and fill factor (%)

The energy conversion efficiency was measured using a 1.5 AM 100 mW/$cm^2$ solar simulator (composed of an Xe lamp [300W, Newport Oriel Instruments Inc. (Irvine, CA)], AM1.5 filter, and Keithley SMU2400), and the fill factor was calculated using the obtained energy conversion efficiency given by an Equation below:

Equation

$$\text{Fill factor (\%)} = \{(J \times V)_{max}\} \;/\; \{J_{sc} \times J_{oc}\} \times 100$$

In the above Equation, J denotes a Y-axis value of an energy conversion efficiency curve, V denotes an X-axis value of the energy conversion efficiency curve, and $J_{sc}$ and $V_{oc}$ denotes intercept values of each axis

Table 3

| Dye | $J_{sc}$ (mAcm$^{-2}$) | $V_{oc}$ (V) | FF | $\eta$ (%) |
|---|---|---|---|---|
| JK-108 | 19.2 | 0.69 | 0.70 | 9.42 |
| JK-105 | 17.7 | 0.71 | 0.71 | 8.85 |
| N-719 | 18.2 | 0.71 | 0.71 | 9.26 |

From the results shown in Table 3, it is shown that the dye-sensitized solar cells of Preparation Examples 1 and 2 have higher efficiency than that of the dye-sensitized solar cell of Comparative Preparation Example 1 using the conventional organic dye.

Variation in current with respect to voltage of each of the dye-sensitized solar cells of Preparation Examples 1 and 2 was evaluated, and the results are illustrated in FIG. 4.

FIG. 4 is a graph showing variation in current with respect to voltage of dye-sensitized solar cells manufactured according to Preparation Examples 1 and 2. Referring to FIG. 4, it is shown that the dye-sensitized solar cells of Preparation Examples 1 and 2 each have excellent photoelectric conversion efficiency.

As described above, according to the one or more of the above embodiments, a dye-sensitized solar cell with enhanced photoelectric conversion efficiency may be manufactured using a ruthenium complex with excellent thermal stability.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A ruthenium complex represented by Formula 1 below:

Formula 1

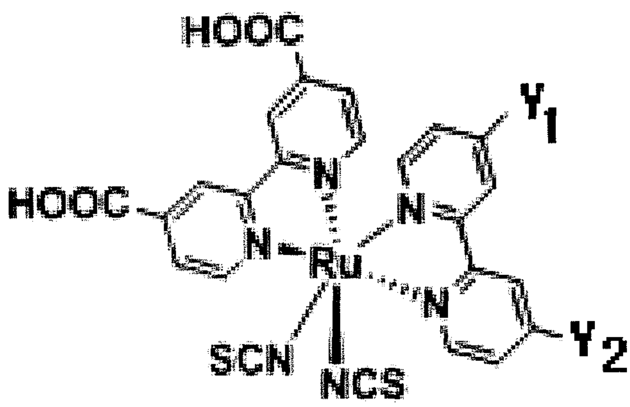

wherein $Y_1$ and $Y_2$ are each independently selected from the group represented by Formula 2A below,

Formula 2A

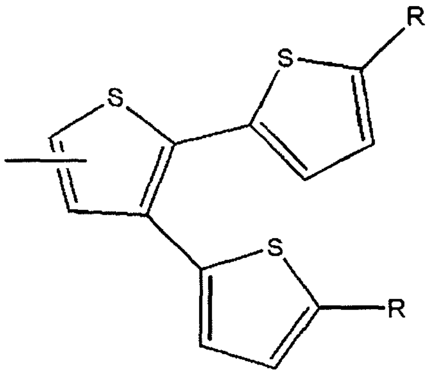

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

**2.** The ruthenium complex of claim 1, wherein the group represented by Formula 2A is a group represented by the following Formula 3A:

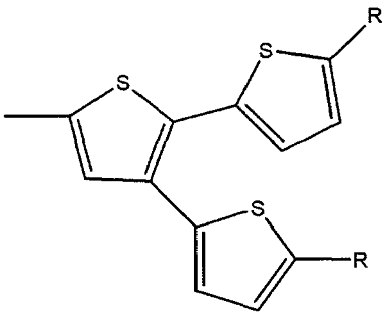

Formula 3A

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

**3.** The ruthenium complex of any one of claims 1 and 2, wherein the compound represented by Formula 1 is a compound represented by Formula 5 below:

Formula 5

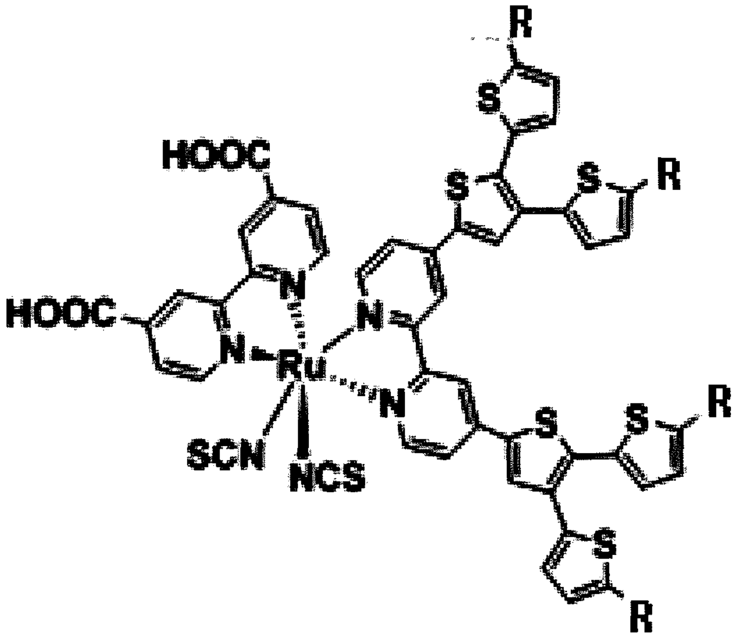

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and preferably R is a hexyl group.

**4.** A dye-sensitized solar cell (9) comprising:

a first electrode (11), a light absorption layer (13) formed on a surface of the first electrode (11), a second electrode (21) disposed to face the first electrode (11) on the face on which the light absorption layer (13) is formed, and an electrolyte (30) disposed between the first electrode (11) and the second electrode (21), the light absorption layer (13) being porous to the electrolyte (30); and
a dye (15) adsorbed onto the light absorption layer (13) comprising a ruthenium complex represented by Formula 1 below.

Formula 1

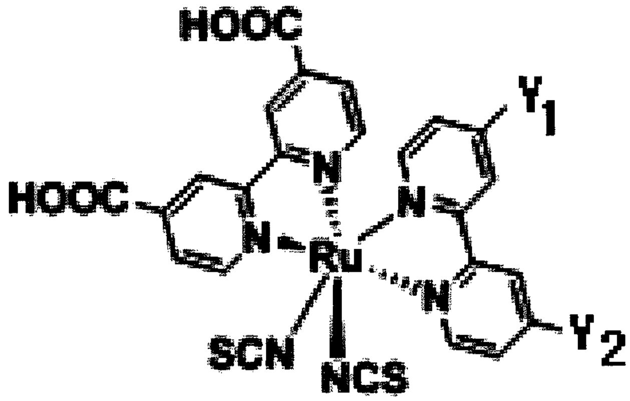

wherein $Y_1$ and $Y_2$ are each independently selected from the group represented by Formula 2A below,

Formula 2A

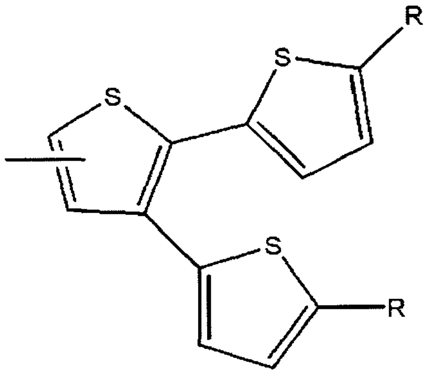

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

**5.** The dye-sensitized solar cell (9) of claim 4, wherein, in the group represented by Formula 2A are groups represented by the following Formula 3A:

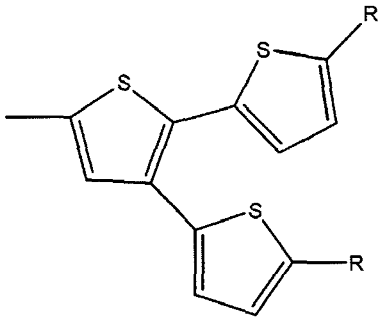

Formula 3A

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

**6.** The dye-sensitized solar cell (9) of any one of claims 4 and 5, wherein the compound represented by Formula 1 is a compound represented by Formula 5 below:

Formula 5

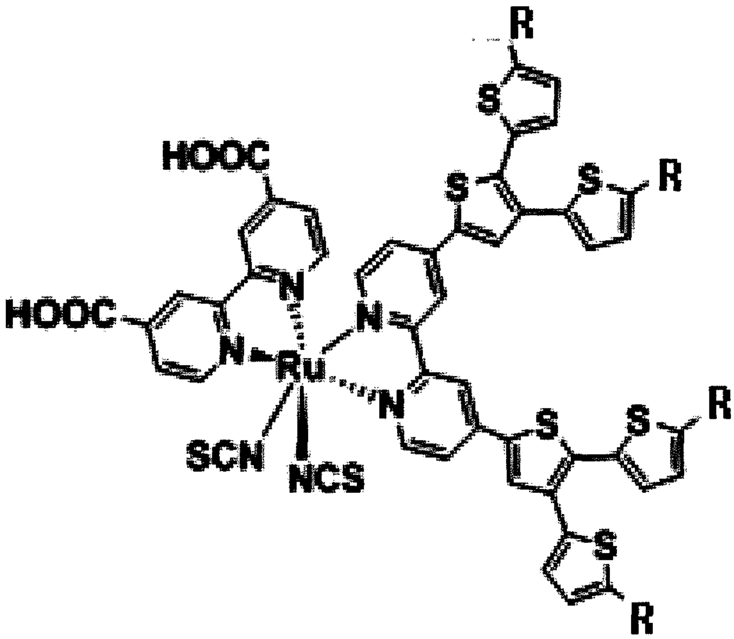

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and preferably R is a hexyl group.

**7.** The dye-sensitized solar cell (9) of any one of claims 4 to 6, further comprising a metal oxide film formed between the light absorption layer (13) and the first electrode (11).

**8.** A method of preparing the ruthenium complex of Formula 1 comprising:

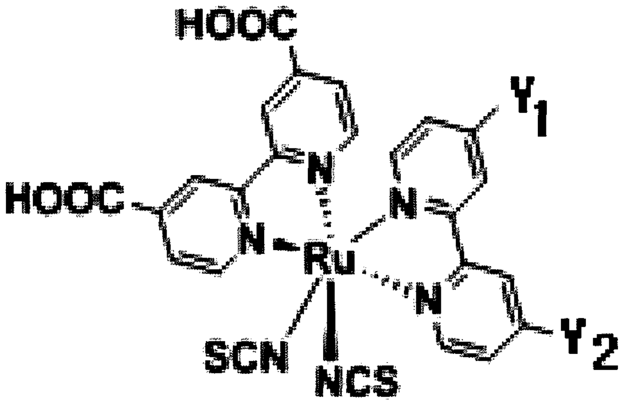

adding Compound (B) (below) to a compound represented by Formula 6 (below)

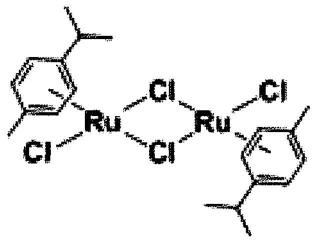

(B)

Formula 6

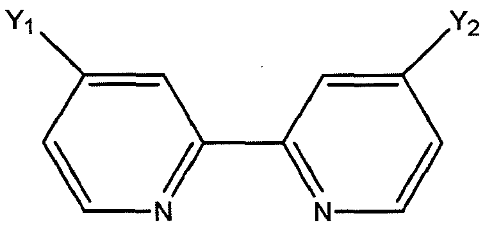

performing a first heat treatment on the mixture;
adding 2,2'-bipyridyl-4,4'-dicarboxylic acid Compound (C) (below) to the mixture:

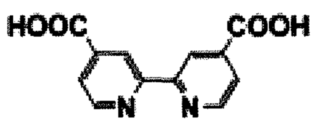

(C)

performing a second heat treatment on the resultant mixture;
adding $NH_4NCS$ to the reaction mixture;
and performing a third heat-treatment on the resultant mixture to obtain the ruthenium compound of Formula 1;
wherein $Y_1$ and $Y_2$ are each independently selected from the group represented by
Formula 2A below,

Formula 2A

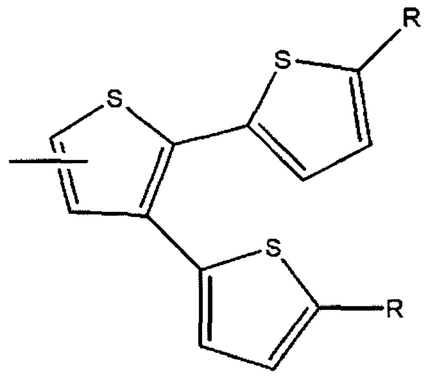

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group.

**9.** The method according to claim 8, wherein the first heat-treatment process is performed at a temperature of from 50 to 200°C, and the second and third heat-treatment processes are performed at a temperature of from 100 to 200°C.

**10.** The method according to any one of claims 8 and 9, wherein, in Formula 1, $Y_1$ and $Y_2$ are each independently a group represented by the following formula:

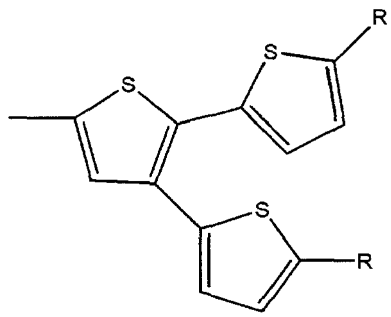

wherein R is hydrogen, a substituted or unsubstituted $C_1$-$C_{30}$ alkyl group, a substituted or unsubstituted $C_1$-$C_{30}$ alkoxy group, a substituted or unsubstituted $C_6$-$C_{30}$ aryl group, a substituted or unsubstituted $C_2$-$C_{30}$ heteroaryl group, a substituted or unsubstituted $C_2$-$C_{30}$ alkynyl group, a substituted or unsubstituted $C_3$-$C_{30}$ carbocyclic group, a substituted or unsubstituted $C_2$-$C_{30}$ heterocyclic group, a halogen atom, a hydroxyl group, a cyano group, a thiol group, or an amino group, and preferably R is a hexyl group.

FIG. 1

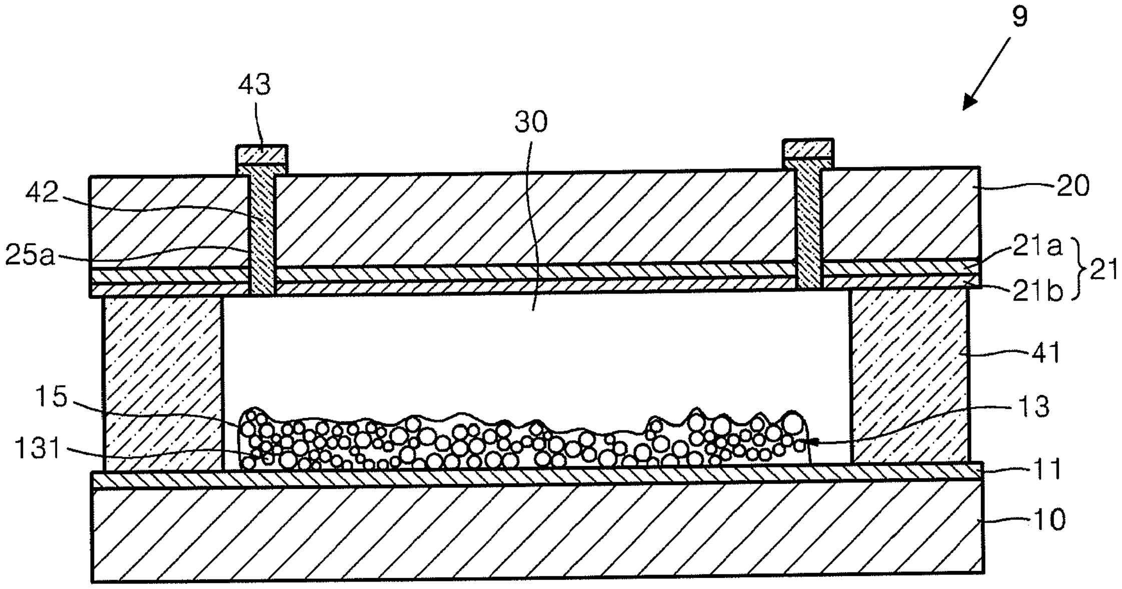

FIG. 2

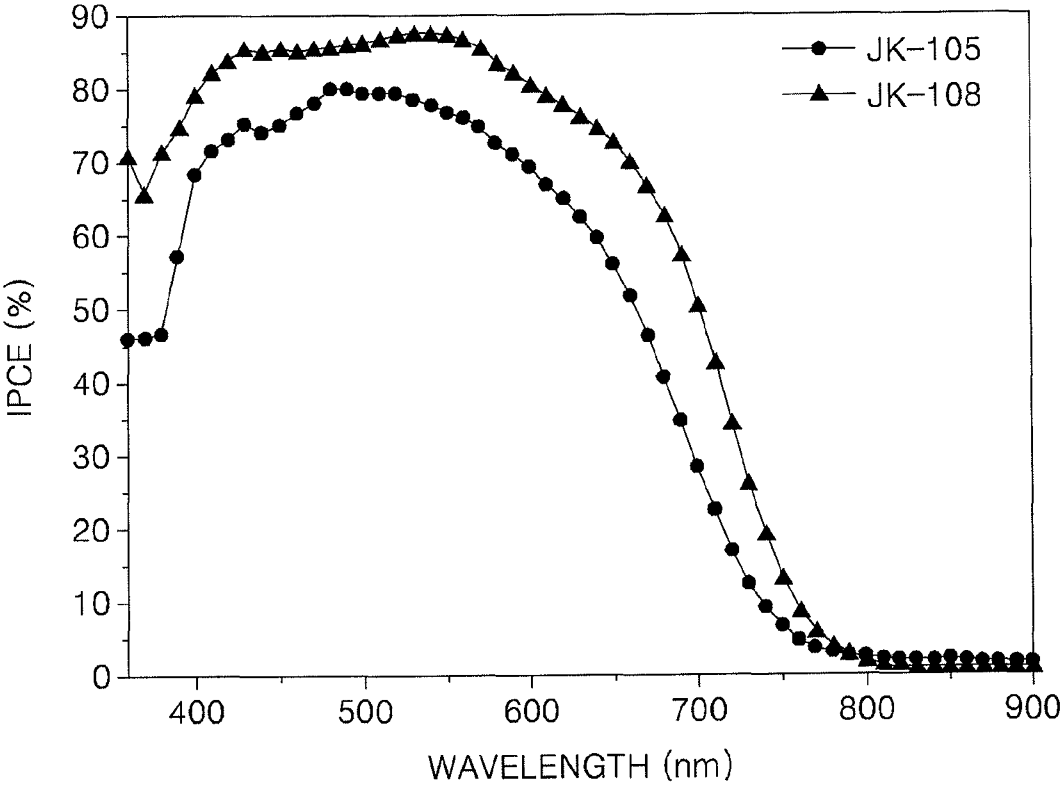
IPCE (%)
90
80
70
60
50
40
30
20
10
0
400
500
600
700
800
900
WAVELENGTH (nm)
JK-105
JK-108

FIG. 3

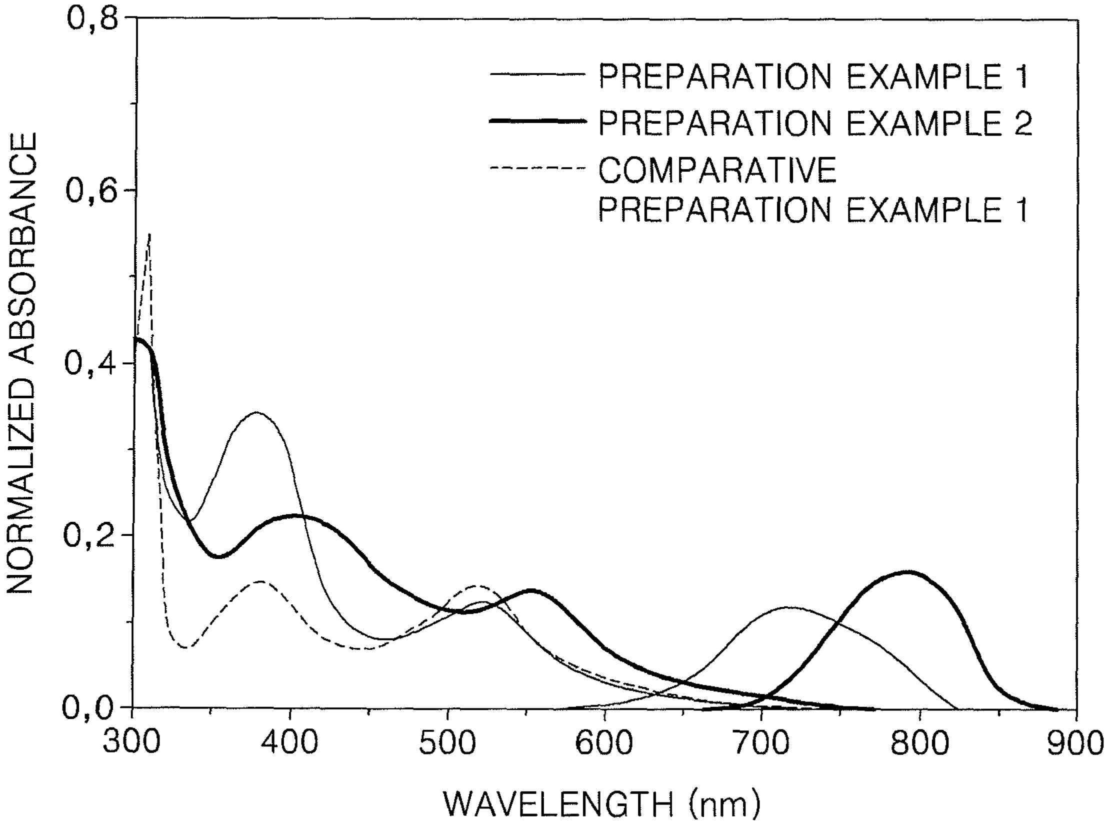
PREPARATION EXAMPLE 1
PREPARATION EXAMPLE 2
COMPARATIVE PREPARATION EXAMPLE 1
NORMALIZED ABSORBANCE
0,8
0,6
0,4
0,2
0,0
300
400
500
600
700
800
900
WAVELENGTH (nm)

FIG. 4

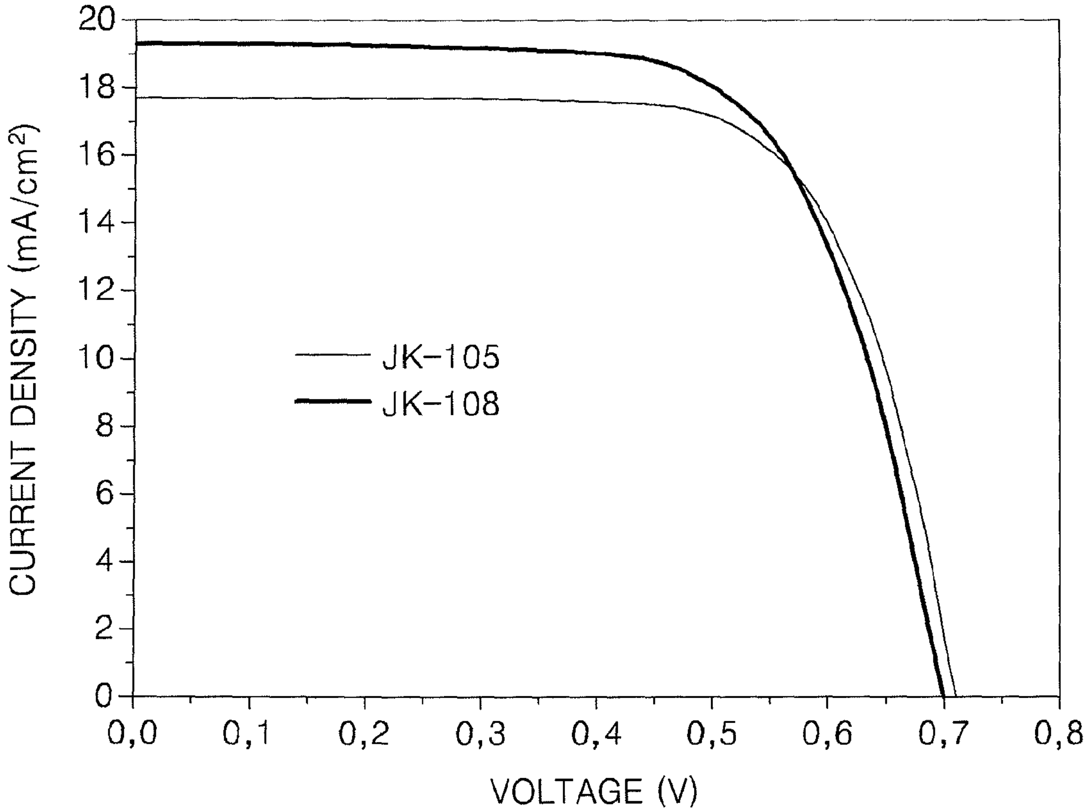
CURRENT DENSITY (mA/cm2)
VOLTAGE (V)
JK-105
JK-108
20
18
16
14
12
10
8
6
4
2
0
0,0
0,1
0,2
0,3
0,4
0,5
0,6
0,7
0,8

Europäisches Patentamt
European Patent Office
Office européen des brevets

# EUROPEAN SEARCH REPORT

Application Number
EP 13 18 2301

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SAUVAGE FREDERIC ET AL: "A Dendritic Oligothiophene Ruthenium Sensitizer for Stable Dye-Sensitized Solar Cells", CHEMSUSCHEM, WILEY - VCH VERLAG GMBH & CO. KGAA, DE, IT, vol. 2, no. 8, 1 January 2009 (2009-01-01), pages 761-768, XP008155491, ISSN: 1864-5631, DOI: 10.1002/CSSC.200900058 [retrieved on 2009-06-30] * the whole document * ----- | 1-10 | INV. H01G9/20<br>ADD. C07F15/00 C09B57/10 |
| A | US 2009/209761 A1 (WU CHUN-GUEY [TW] ET AL) 20 August 2009 (2009-08-20) * paragraph [0031] - paragraph [0056] * ----- | 1-10 | |
| | | | TECHNICAL FIELDS SEARCHED (IPC) |
| | | | H01G<br>H01L<br>C07F |

The present search report has been drawn up for all claims

1

| Place of search | Date of completion of the search | Examiner |
|---|---|---|
| The Hague | 9 September 2013 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 13 18 2301

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2013

| Patent document cited in search report | Publication date | Patent family member(s) | Publication date |
|---|---|---|---|
| US 2009209761 A1 | 20-08-2009 | JP 5008615 B2 | 22-08-2012 |
| | | JP 2009200028 A | 03-09-2009 |
| | | TW 200936575 A | 01-09-2009 |
| | | US 2009209761 A1 | 20-08-2009 |

EPO FORM P0459

For more details about this annex : see Official Journal of the European Patent Office, No. 12/82